# EUROPÄISCHE PATENTSCHRIFT

(11) **EP 4 099 036 B1**
(45) Veröffentlichungstag und Bekanntmachung des Hinweises auf die Patenterteilung: **04.10.2023**
(21) Anmeldenummer: 21176804.9
(22) Anmeldetag: 31.05.2021
(51) Int. Cl.: G01R 31/367, G06N 3/044, G06N 3/045, G06N 3/088

(54) **SIMULATION EINES LEISTUNGSVERHALTENS EINES ENERGIESPEICHERS**
SIMULATION OF THE PERFORMANCE OF AN ENERGY STORAGE DEVICE
SIMULATION D'UN COMPORTEMENT DE PERFORMANCE D'UN ACCUMULATEUR D'ÉNERGIE

(43) Veröffentlichungstag der Anmeldung: 07.12.2022
(73) Patentinhaber: Novum engineerING GmbH, 01067 Dresden (DE)
(72) Erfinder: Boß, Valentin, 01127 Dresden (DE); Saidani, Amin, 01239 Dresden (DE)
(74) Vertreter: Ter Meer Steinmeister & Partner

(56) Entgegenhaltungen:
- CN-A- 110 488 203
- CN-A- 111 832 220
- MASHLAKOV ALEKSEI ET AL: "Probabilistic Forecasting of Battery Energy Storage State-of-Charge under Primary Frequency Control", IEEE JOURNAL ON SELECTED AREAS IN COMMUNICATIONS, IEEE SERVICE CENTER, PISCATAWAY, US, Bd. 38, Nr. 1, 6. November 2019 (2019-11-06), Seiten 96-109, XP011768873, ISSN: 0733-8716, DOI: 10.1109/JSAC.2019.2952195 [gefunden am 2020-01-29]

## Beschreibung

Die Erfindung betrifft ein Simulationssystem zum Simulieren eines Leistungsverhaltens eines Energiespeichers.

DE 102019121461 B3 und WO 2021/023346 A1 beschreiben eine Technik zur Zustandsüberwachung einer Batterie, beispielsweise einer Lithium-Ionen-Batterie, unter Verwendung eines thermischen Simulationsmodells.

DE 102019111979 A1 und WO 2020/224724 A1 beschreiben ein Verfahren zur Server-seitigen Charakterisierung einer wiederaufladbaren Batterie, bei dem eine Simulation eines elektrischen Zustands der Batterie und eines thermischen Zustands der Batterie durchgeführt wird.

CN 111 832 220 A und Mashlakov A. et Al : "Probabilistic Forecasting of Battery Energy Storage State-of-Charge under Primary Frequency Control", IEEE Jour. on Selected Areas in Comm. vol. 38, no. 1, 2019-11-06, beschreiben eine Simulierung von Batterien durch ein Encoder-Decoder Modell in einem rekurrenten neuronalen Netzwerk.

Aufgabe der Erfindung ist es, ein neuartiges Simulationssystem zum Simulieren eines Energiespeichers zu schaffen, das es erlaubt, basierend auf gemessenen Daten einer jeweiligen Speichereinheit des Energiespeichers ein zukünftiges Verhalten des Energiespeichers zu simulieren. Wünschenswert ist es, daraus Rückschlüsse auf einen Zustand der Speichereinheit oder des Energiespeichers ziehen zu können.

Die Aufgabe wird erfindungsgemäß gelöst durch ein Simulationssystem zum Simulieren eines Leistungsverhaltens wenigstens einer Speichereinheit eines Energiespeichers, wobei das Simulationssystem aufweist: wenigstens ein jeweiliges Modell für eine dem Modell zugeordnete jeweilige Speichereinheit des Energiespeichers, wobei das Modell ein Encoder-Decoder-Modell mit einem Encoder und einem Decoder umfasst, wobei das Encoder-Decoder-Modell wenigstens ein rekurrentes neuronales Netzwerk oder wenigstens ein neuronales Netzwerk mit einer Transformer-Architektur umfasst, wobei der Encoder dazu eingerichtet ist, eine Encoder-Eingabesequenz zu verarbeiten, die einen gemessenen zeitlichen Verlauf von Strom und Spannung oder Leistung und Spannung der dem Modell zugeordneten Speichereinheit beschreibt, wobei das Verarbeiten der Encoder-Eingabesequenz umfasst, aus der Encoder-Eingabesequenz einen initialen Zustand des Modells zu erzeugen, und wobei der Decoder dazu eingerichtet ist, ausgehend von dem initialen Zustand des Modells eine Decoder-Eingabesequenz zu verarbeiten, die einen zu simulierenden zeitlichen Verlauf des Stroms bzw. der Leistung der dem Modell zugeordneten Speichereinheit beschreibt, wobei das Verarbeiten der Decoder-Eingabesequenz umfasst, ausgehend von dem initialen Zustand des Modells aus der Decoder-Eingabesequenz eine Decoder-Ausgabesequenz zu erzeugen, die einen simulierten zeitlichen Verlauf der Spannung der dem Modell zugeordneten Speichereinheit beschreibt. Die Decoder-Ausgabesequenz und/oder der davon beschriebene zeitliche Verlauf der Spannung kann vom System ausgegeben werden.

Der Decoder des Encoder-Decoder-Modells ist somit dazu eingerichtet, ausgehend von dem initialen Zustand ein nachfolgendes Leistungsverhalten zu simulieren, bei dem ein zeitlicher Verlauf des Stroms bzw. der Leistung vorgegeben wird, um einen simulierten zeitlichen Verlauf der Spannung zu erhalten. Um einen Zustand des Modells zu erzeugen, der den Zustand der realen Speichereinheit nach Durchlaufen des gemessenen zeitlichen Verlaufs des Stroms und der Spannung oder der Leistung und der Spannung im Modell abbildet, erfolgt das Verarbeiten der Encoder-Eingabesequenz durch den Encoder des Encoder-Decoder-Modells. Dieses Initialisieren des Modells bringt das Modell in den initialen Zustand.

Eine Grundidee der Erfindung ist es somit, ein Simulationssystem zum Simulieren eines Strom-Spannungs-Verhaltens oder eines Leistungs-Spannungs-Verhaltens eines Energiespeichers zu schaffen, welches es durch Nutzung eines rekurrenten neuronalen Netzwerks ermöglicht, basierend auf gemessenen Daten einer jeweiligen Speichereinheit des Energiespeichers für einen anschließenden hypothetischen Stromverlauf oder Leistungsverlauf einen Spannungsverlauf der Speichereinheit zu simulieren. Dies kann es beispielsweise ermöglichen, aus einem simulierten Spannungsverlauf Zustandseigenschaften der Speichereinheit oder des Energiespeichers schätzen zu können. Anhand von aufgezeichneten Felddaten und Methoden des maschinellen Lernens wird das Modell (oder Batteriemodell) erstellt, oder mehrere Modelle für jeweilige Speichereinheiten. Das Modell ermöglicht nahezu echtzeitfähige Simulationen, anhand derer der Batteriezustand ermittelt werden kann. Vorteilhaft ist, dass die Simulation anhand des Modells eine präzise Vorhersage des Verhaltens der Speichereinheit und somit des Energiespeichers ermöglicht, anhand dessen beispielsweise gewünschte Zustandsgrößen wie bspw. SoH (State of Health), SoC (State of Charge) und SoF (State of Funktion) abgeleitet werden können. Somit können frühzeitig etwaige Schwachstellen gefunden, ein Betrieb des Energiespeichers durch ein Energiespeicher-Managementsystem optimiert werden (Senkung des Stroms, der Leistung oder der Belastung) und/oder eine Ausgabe von Wartungsinformationen für die entsprechenden Speichereinheiten bzw. Zellen oder Module erfolgen. Der selbstverstärkende Effekt der Batteriealterung wird somit hinausgezögert und eine verlängerte Lebensdauer der Batterien ermöglicht.

Besonders vorteilhaft ist, dass ein Modell geschaffen wird, welches zum einen durch maschinelles Lernen besonders gut an das Leistungsverhalten einer realen Speichereinheit angepasst werden kann, ohne dass eine physikalische Modellbildung anhand von internen Merkmalen der Speichereinheit benötigt wird, und welches zum anderen zur Simulation konkreter Anforderungsprofile verwendet werden kann. So haben herkömmliche Modelle zur Batteriezustandsvorhersage häufig das Problem, dass ein initialer Zustand hinsichtlich des Ladezustands, SoC, (State of Charge) und des SoH (State of Health) der Batterie ermittelt werden muss. Die Encoder-Decoder-Modellarchitektur lernt hingegen, den initialen Zustand aus den historischen Daten der Zelle zu ermitteln, und modelliert diesen nicht über eine Annahme. Die modellinterne Repräsentation ist mathematischer Natur und hat ausschließlich zum Ziel, das Batterieverhalten zu approximieren, nicht jedoch das Verhalten physikalisch zu interpretieren. Das Modell kann anhand von historischen Messdaten trainiert werden. Weiter kann es beispielsweise auch ermöglicht werden, Modellabweichungen durch Online-Training und eine daraus resultierende Verbesserung des Modells automatisiert zu verringern. In der Praxis sind Batteriespannung und -strom häufig die einzig messbaren physikalischen Grö-ßen, die eine Aussage über das Batterieverhalten erlauben. Diese können durch das Simulationssystem besonders gut ausgewertet werden. Das Modell kann kontinuierlich im Betrieb des Energiespeichers angepasst werden.

Das Leistungsverhalten kann beispielsweise ein Strom-Spannungs-Verhalten oder ein Leistung-Spannung-Verhalten umfassen. Dabei kann ein Strom-Spannungs-Verhalten den Verlauf der Spannung in Abhängigkeit von dem Verlauf des Stroms beschreiben.

Ein Leistung-Spannung-Verhalten kann den Verlauf der Spannung in Abhängigkeit von dem Verlauf der Leistung beschreiben.

Die Encoder-Eingabesequenz beschreibt einen gemessenen zeitlichen Verlauf von Strom und Spannung oder Leistung und Spannung der dem Modell zugeordneten - Speichereinheit. Dies kann durch Angabe von Werten von Strom und Spannung erfolgen. Dies kann aber beispielsweise auch durch Angabe von Werten von Leistung und Spannung erfolgen, da beispielsweise der Strom durch Angabe von Spannung und Leistung definiert werden kann.

Rekurrente neuronale Netzwerke sind eine Klasse von künstlichen neuronalen Netzwerken, die Verbindungen zwischen Neuronen oder Knoten einer Schicht zu Neuronen oder Knoten einer gleichen oder vorangegangenen Schicht aufweisen und dadurch speziell an die Verarbeitung sequentieller Eingabedaten angepasst sind. Ein neuronales Netzwerk mit einer Transformer-Architektur wird auch als Transformer bezeichnet und ist eine Deep-Learning-Architektur, die speziell an die Verarbeitung sequentieller Eingabedaten angepasst ist.

Vorzugsweise ist das Simulationssystem ein Simulationssystem zum Simulieren eines Leistungsverhaltens mehrerer Speichereinheiten eines Energiespeichers, wobei das Simulationssystem aufweist: Wenigstens ein jeweiliges Modell für eine dem Modell zugeordnete jeweilige Speichereinheit des Energiespeichers. In jedem Modell werden somit eine jeweilige Encoder-Eingabesequenz und eine jeweilige Decoder-Eingabesequenz verarbeitet, und es wird ein jeweilige Decoder-Ausgabesequenz erzeugt. Die beschriebenen Operationen erfolgen jeweils für die einzelnen Modelle, die den betreffenden Speichereinheiten des Energiespeichers zugeordnet sind, und von denen die Messdaten stammen. Eine Kombination der Modelle erlaubt eine Vorhersage des Verhaltens des (gesamten) Energiespeichers. Es kann eine kombinierte Auswertung der Decoder-Ausgabesequenzen erfolgen. Basierend auf den jeweiligen erzeugten Decoder-Ausgabesequenzen, die jeweils einen simulierten zeitlichen Verlauf der Spannung der dem jeweiligen Modell zugeordneten Speichereinheit beschreiben, kann beispielsweise ein simulierter zeitlicher Verlauf einer Gesamtspannung des Energiespeichers bestimmt werden, oder es kann ein Schätzwert für einen Zustandsparameter bestimmt werden, der einen Zustand des Energiespeichers kennzeichnet, oder es kann prognostiziert werden, ob der Energiespeicher ein Lastszenario erfüllen kann (wie im Einzelnen nachfolgend für eine jeweilige Speichereinheit beschrieben wird). Die Decoder-Ausgabesequenz und/oder der davon beschriebene zeitliche Verlauf der Spannung und/oder das Ergebnis der Auswertung oder des Überprüfens und/oder Information über die Prognose kann von dem System ausgegeben werden.

Der Energiespeicher kann als Speicher für elektrische Energie bezeichnet werden. Er kann ein Speicher für elektrische Energie auf elektrischer oder elektrochemischer Basis sein. Der Energiespeicher kann ein elektrischer Energiespeicher oder ein elektrochemischer Energiespeicher sein, beispielsweise eine Batterie. Nachfolgend wird der Energiespeicher synonym auch als Batterie bezeichnet.

Das Leistungsverhalten des Energiespeichers wird (insbesondere) auf der Ebene der Speichereinheit(en) simuliert. Eine Simulation jeder einzelnen Zelle bzw. Speichereinheit erlaubt eine Prognose über das Verhalten und den Zustand des gesamten Speichers.

Der Energiespeicher ist vorzugsweise dazu eingerichtet, Messungen von Strom und Spannung oder Leistung und Spannung der jeweiligen Speichereinheit zu gestatten. Insbesondere kann der Energiespeicher dazu eingerichtet sein, im Betrieb des Energiespeichers Messungen von Strom und Spannung oder Leistung und Spannung der jeweiligen Speichereinheit zu gestatten. Bei der jeweiligen Speichereinheit kann es sich beispielsweise um eine Speichereinheit eines aus mehreren Speichereinheiten aufgebauten Energiespeichers handeln. Die jeweilige Speichereinheit kann beispielsweise eine Speicherzelle oder Batteriezelle sein, oder kann ein Speichermodul oder Batteriemodul sein, welches mehrere Speicherzellen umfasst. In der Praxis wird als Speichereinheit vorzugsweise die kleinste Einheit des Energiespeichers gewählt, von der Stromdaten/Leistungsdaten und Spannungsdaten gemessen und dem Simulationssystem zur Verfügung gestellt werden können. Die Speichereinheit kann beispielsweise eine Vielzahl von Speicherzellen umfassen, die in Reihenschaltung und/oder Parallelschaltung angeordnet sein können. Speichereinheiten, die durch die Modelle modelliert werden, sind vorzugsweise solche, für die jeweilige gemessene Werte einer Spannung und eines Stroms bzw. einer Leistung zur Verfügung stehen oder gemessen werden können.

Die Encoder-Eingabesequenz beschreibt einen gemessenen zeitlichen Verlauf von Strom und Spannung oder Leistung und Spannung der dem Modell zugeordneten - Speichereinheit. Sie kann beispielsweise Werte der Spannung und Werte des Stroms oder einer Ladungsmenge oder der Leistung umfassen. Vorzugsweise beschreibt die Encoder-Eingabesequenz einen aktuellen und/oder zuletzt gemessenen zeitlichen Verlauf von Strom und Spannung oder Leistung und Spannung der dem Modell zugeordneten Speichereinheit. Der initiale Zustand des Modells repräsentiert dann einen aktuellen Zustand der entsprechenden Speichereinheit.

Das Simulationssystem kann eingerichtet sein, basierend auf einer in das Simulationssystem eingespeisten Messreihe von Daten, die einen gemessenen zeitlichen Verlauf von Strom und Spannung oder Leistung und Spannung der dem Modell zugeordneten - Speichereinheit umfassen, eine entsprechende Encoder-Eingabesequenz bereitzustellen und dem jeweiligen Modell zur Verarbeitung zuzuführen.

Zur Vereinfachung der Berechnungen umfassen die Encoder-Eingabesequenz und die Decoder-Eingabesequenz (sowie ggf. die nachfolgend beschriebene Trainingssequenz) einheitlich vorzugsweise Werte eines Stroms, Werte einer Ladungsmenge, Werte einer Leistung, und/oder sowohl Werte eines Stroms als auch Werte einer Ladungsmenge. Eine Ladungsmenge entspricht einem zeitlichen Integral eines Stroms.

Häufig liegen in der Praxis die Messdaten nicht in konstanten zeitlichen Intervallen vor. Das Simulationssystem kann eingerichtet sein, aus einem gemessenen zeitlichen Verlauf von Strom und Spannung oder Leistung und Spannung der dem Modell zugeordneten Speichereinheit eine Encoder-Eingabesequenz mit Elementen in einem festen Zeitraster zu erzeugen, beispielsweise durch Interpolation. Ebenso kann das Simulationssystem eingerichtet sein, aus einem gemessenen zeitlichen Verlauf des Stroms oder der Spannung der dem Modell zugeordneten Speichereinheit eine Decoder-Eingabesequenz mit Elementen in einem festen Zeitraster zu erzeugen. In der Praxis sind bei vielen Anwendungen Intervalle im Bereich von 1s bis 10s ausreichend.

Der Zustand des Modells kann beispielsweise durch einen Zustandsvektor des Modells repräsentiert werden, der von dem Encoder erzeugt wird und von dem Decoder verarbeitet wird. Das Encoder-Decoder-Modell ist besonders gut geeignet für die Repräsentation eines Zustands der Speichereinheit, Initialisierung durch die Encoder-Eingabesequenz, und Simulieren des anschließenden Verhaltens der Speichereinheit durch Verarbeiten der Decoder-Eingabesequenz.

Beispielsweise kann der Encoder ein rekurrentes neuronales Netzwerk sein. Beispielsweise kann der Decoder ein rekurrentes neuronales Netzwerk sein.

Beispielsweise kann das Encoder-Decoder-Modell ein neuronales Netzwerk mit einer Transformer-Architektur umfassen, und die Transformer-Architektur kann den Encoder und den Decoder umfassen. Mit anderen Worten, das Encoder-Decoder-Modell kann ein Transformer-Modell sein, welches den Encoder und den Decoder umfasst.

Vorzugsweise umfasst der jeweilige Encoder eine erste Encoder-Schicht und zumindest eine zweite Encoder-Schicht. Eine oder die erste Decoder-Schicht ist vorzugsweise der zweiten Encoder-Schicht nachgeordnet. Die erste Encoder-Schicht ist vorzugsweise eingerichtet, die Encoder-Eingabesequenz als Eingabe zu verarbeiten. Die zweite (oder eine letzte zweite) Encoder-Schicht ist vorzugsweise eingerichtet, den initialen Zustand des Modells zu erzeugen.

Vorzugsweise umfasst der jeweilige Decoder eine erste Decoder-Schicht und zumindest eine zweite Decoder-Schicht. Vorzugsweise ist die zweite Decoder-Schicht der ersten Decoder-Schicht nachgeordnet. Die erste Decoder-Schicht ist dem Encoder nachgeordnet. Die erste Decoder-Schicht ist vorzugsweise eingerichtet, ausgehend von dem initialen Zustand des Modells die Decoder-Eingabesequenz zu verarbeiten. Die zweite (oder eine letzte zweite) Decoder-Schicht ist vorzugsweise eingerichtet, die Decoder-Ausgabesequenz zu erzeugen.

Der Ausdruck "nachgeordnet" bedeutet hier: In (Haupt-)Verarbeitungsrichtung nachgeordnet.

Die erste Encoder-Schicht, die zweite Encoder-Schicht, die erste Decoder-Schicht und die zweite Decoder-Schicht können beispielsweise jeweils ein neuronales Netzwerk umfassen und/oder Teilschichten wenigstens eines neuronalen Netzwerks des Encoders bzw. Decoders umfassen. Die Anzahlen der Encoder-Schichten und Decoder-Schichten können beispielsweise empirisch ermittelt werden und erhöht werden, bis eine zufriedenstellende Funktion erreicht ist.

Wichtige Einflussgrößen auf das Batterieverhalten sind Temperatur, Strom bzw. Leistung und Druck auf die Batterie. Die Spannung ergibt sich vereinfacht in Abhängigkeit dieser Größen, dem Ladezustand und der Alterung der Batterie.

In Ausführungsformen beschreibt die Encoder-Eingabesequenz den gemessenen zeitlichen Verlauf von Strom und Spannung oder Leistung und Spannung der dem Modell zugeordneten Speichereinheit und einen gemessenen zeitlichen Verlauf einer Temperatur.

In Ausführungsformen beschreibt die Decoder-Eingabesequenz den zu simulierenden zeitlichen Verlauf des Stroms oder der Leistung der dem Modell zugeordneten Speichereinheit und einen zu simulierenden zeitlichen Verlauf einer Temperatur.

Dies ermöglicht es, auch die Temperatur für die Modellierung des Zustands der betreffenden Speichereinheit zu berücksichtigen. Die Temperatur ist eine wichtige Einflussgröße für das Batterieverhalten einer Batterie. Die Temperatur kann beispielsweise eine Umgebungstemperatur der Speichereinheit oder des Energiespeichers sein, oder eine Temperatur der Speichereinheit oder des Energiespeichers.

In Ausführungsformen ist der jeweilige Encoder und/oder der jeweilige Decoder ein rekurrentes neuronales Netzwerk mit einer LSTM-Architektur oder einer GRU-Architektur, oder ist ein Convolutional Neural Network, CNN.

Dabei bezeichnet LSTM (long short-term memory) eine Architektur, bei der eine Zelle des neuronalen Netzwerks ein Input-Gate, ein Forget-Gate und ein Output-Gate hat. Es kann beispielsweise eine B-LSTM-Architektur vorgesehen sein (bidirectional long short-term memory). GRU (gated recurrent unit) bezeichnet eine Architektur, bei der eine Zelle des neuronalen Netzwerks ein Input-Gate und ein Forget-Gate hat.

Dies ermöglicht insbesondere bei mehrschichtigen rekurrenten neuronalen Netzwerken eine verbesserte Anpassung des Modells an Trainingsdaten oder an die Encoder-Eingabesequenz.

In Ausführungsformen ist das Simulationssystem eingerichtet, zu prognostizieren, ob die jeweilige Speichereinheit des Energiespeichers ein Lastszenario erfüllen kann, wobei das Prognostizieren umfasst: Verarbeiten einer jeweiligen Encoder-Eingabesequenz durch den Encoder des Modells, dem die jeweilige Speichereinheit zugeordnet ist, wobei die Encoder-Eingabesequenz einen zuletzt gemessenen zeitlichen Verlauf von Strom und Spannung oder Leistung und Spannung der dem Modell zugeordneten Speichereinheit beschreibt, wobei das Verarbeiten der Encoder-Eingabesequenz umfasst, aus der Encoder-Eingabesequenz einen initialen Zustand des Modells zu erzeugen; und, ausgehend von dem initialen Zustand des Modells, Verarbeiten einer jeweiligen Decoder-Eingabesequenz durch den Decoder des Modells, dem die jeweilige Speichereinheit zugeordnet ist, wobei die Decoder-Eingabesequenz einen zu simulierenden zeitlichen Verlauf des Stroms oder der Leistung der dem Modell zugeordneten Speichereinheit gemäß dem Lastszenario beschreibt, wobei das Verarbeiten der Decoder-Eingabesequenz umfasst, ausgehend von dem initialen Zustand des Modells aus der Decoder-Eingabesequenz eine Decoder-Ausgabesequenz zu erzeugen, die einen simulierten zeitlichen Verlauf der Spannung der dem Modell zugeordneten Speichereinheit beschreibt; und Überprüfen, ob die erzeugte Decoder-Ausgabesequenz das Lastszenario erfüllt, und wenn dies der Fall ist, Prognostizieren, dass das Lastszenario erfüllt werden kann, und sonst, Prognostizieren, dass das Lastszenario nicht erfüllt werden kann.

Indem basierend auf dem zuletzt gemessenen zeitlichen Verlauf von Strom und Spannung oder Leistung und Spannung der dem Modell zugeordneten Speichereinheit das Modell initialisiert wird, kann der initiale Modellzustand somit den aktuellen Zustand der Speichereinheit repräsentieren. Dies ermöglicht es, eine Vorhersage über die Erfüllbarkeit des Lastszenarios zu treffen. Insbesondere ist es möglich, eine Aussage über die Fähigkeit des Systems zu geben, ein individuell definiertes Lastszenario zu erfüllen. Sinkt beispielsweise der simulierte zeitliche Verlauf der Spannung auf einen unzulässig niedrigen Wert ab, so kann prognostiziert werden, dass das Lastszenario im gegenwärtigen Zustand der Speichereinheit nicht erfüllt werden kann. Es kann somit überprüft werden, ob der simulierte zeitliche Verlauf der Spannung zusammen mit dem zu simulierenden zeitlichen Verlauf des Stroms oder der Leistung gemäß dem Lastszenario das Lastszenario erfüllt. Das Lastszenario kann beispielsweise eine Mindestspannung beschreiben, die während des beschriebenen Verlaufs des Stroms / der Leistung einzuhalten ist. Das Überprüfen, ob die erzeugte Decoder-Ausgabesequenz das Lastszenario erfüllt, kann beispielsweise umfassen, zu überprüfen, ob der simulierte zeitliche Verlauf der Spannung das Lastszenario erfüllt. Das Überprüfen, ob die erzeugte Decoder-Ausgabesequenz das Lastszenario erfüllt, kann beispielsweise umfassen, zu überprüfen, ob der simulierte zeitliche Verlauf der Spannung die Mindestspannung einhält. Anhand eines Lastszenarios kann auch eine Prognose über auftretende Anomalien im Betrieb der Batterie erstellt werden: Wird ein Lastszenario nicht erfüllt, so kann dies dem Auftreten einer Anomalie entsprechen. Die Decoder-Ausgabesequenz und/oder der davon beschriebene zeitliche Verlauf der Spannung und/oder das Ergebnis der Auswertung oder des Überprüfens und/oder Information über die Prognose kann von dem System ausgegeben werden.

Es kann beispielsweise eine Decoder-Eingabesequenz verwendet werden, die ein zu simulierendes Stromentnahmeprofil beschreibt, das einen Mindeststrom über eine Zeitdauer aufrechterhält, und es kann die erzeugte Decoder-Ausgabesequenz daraufhin ausgewertet werden, nach welcher Zeitdauer eine Mindestspannung des Lastszenarios unterschritten wird, und/oder ob eine gemäß dem Lastszenario geforderte Zeitdauer erreicht wird. Es kann beispielsweise eine Decoder-Eingabesequenz verwendet werden, die ein zu simulierendes Leistungsprofil beschreibt, das eine Mindestleistung über eine Zeitdauer aufrechterhält, und es kann die erzeugte Decoder-Ausgabesequenz daraufhin ausgewertet werden, nach welcher Zeitdauer eine Mindestspannung des Lastszenarios unterschritten wird, und/oder ob eine gemäß dem Lastszenario geforderte Zeitdauer erreicht wird.

In Ausführungsformen ist das Simulationssystem eingerichtet, einen Zustandsparameter zu schätzen, der einen Zustand der jeweiligen Speichereinheit des Energiespeichers kennzeichnet, wobei das Schätzen des Zustandsparameters umfasst: Verarbeiten einer jeweiligen Encoder-Eingabesequenz durch den Encoder des Modells, dem die jeweilige Speichereinheit zugeordnet ist, wobei die Encoder-Eingabesequenz einen zuletzt gemessenen zeitlichen Verlauf von Strom und Spannung oder Leistung und Spannung der dem Modell zugeordneten Speichereinheit beschreibt, wobei das Verarbeiten der Encoder-Eingabesequenz umfasst, aus der Encoder-Eingabesequenz einen initialen Zustand des Modells zu erzeugen; und, ausgehend von dem initialen Zustand des Modells, Verarbeiten einer jeweiligen Decoder-Eingabesequenz durch den Decoder des Modells, dem die jeweilige Speichereinheit zugeordnet ist, wobei die Decoder-Eingabesequenz einen zu simulierenden zeitlichen Verlauf des Stroms oder der Leistung der dem Modell zugeordneten Speichereinheit beschreibt, wobei das Verarbeiten der Decoder-Eingabesequenz umfasst, ausgehend von dem initialen Zustand des Modells aus der Decoder-Eingabesequenz eine Decoder-Ausgabesequenz zu erzeugen, die einen simulierten zeitlichen Verlauf der Spannung der dem Modell zugeordneten Speichereinheit beschreibt; und Bestimmen eines Schätzwertes für den Zustandsparameter anhand des zu simulierenden zeitlichen Verlaufs des Stroms oder der Leistung und des zugehörigen simulierten Verlaufs der Spannung. Die Decoder-Ausgabesequenz und/oder der davon beschriebene zeitliche Verlauf der Spannung und/oder der Schätzwert kann vom System ausgegeben werden.

Beispielsweise kann so durch simuliertes Entladen der Speichereinheit bis zu einer Entladeschlussspannung der aktuelle Ladezustand als Zustandsparameter geschätzt werden. Es können somit individuelle Zustandsgrößen und Analysefunktionen erstellt werden, die genauere Aussagen über das Batterieverhalten erlauben, als bisher übliche Zustandsgrößen, wie z.B. eine ladungsbasierte Schätzung des SoH oder des SoC. Der zu schätzende Zustandsparameter kann beispielsweise vom Strom- und/oder Leistungsprofil abhängige Zustandsparameter wie SoH, SoC und SoF umfassen.

In Ausführungsformen ist das Simulationssystem eingerichtet, den simulierten zeitlichen Verlauf der Spannung mit einem weiteren, gemessenen zeitlichen Verlauf der Spannung der dem Modell zugeordneten Speichereinheit zu vergleichen und aus dem Vergleichsergebnis einen Indikator für eine Güte des Modells zu bestimmen. Die Decoder-Ausgabesequenz und/oder der davon beschriebene zeitliche Verlauf der Spannung und/oder das Vergleichsergebnis und/oder der Indikator kann von dem System ausgegeben werden.

Vorzugsweise beschreibt dabei die Decoder-Eingabesequenz einen weiteren gemessenen zeitlichen Verlauf des Stroms oder der Leistung der dem Modell zugeordneten Speichereinheit. Der initiale Zustand repräsentiert hier somit den aktuellen Zustand der Speichereinheit, entsprechend dem zuletzt gemessenen zeitlichen Verlauf von Strom und Spannung oder Leistung und Spannung. Dies ermöglicht es, zu überprüfen, wie gut der entsprechende simulierte zeitliche Verlauf der Spannung mit dem zugeordneten gemessenen zeitlichen Verlauf der Spannung übereinstimmt. Dabei ist die simulierte Spannung ein Maß für die Genauigkeit des Modells und in Zusammenhang mit der tatsächlich gemessenen Spannung ein Indikator für die Güte des Modells. Schlussfolgerungen über die Güte des Modells können im Betrieb des Energiespeichers durch Abweichungen der simulierten Spannung von der tatsächlich gemessenen Spannung gezogen werden. Die erreichte Modellgüte kann auf historischen Daten evaluiert werden, die in einer Datenbank gespeichert werden. Da die Batteriespannung in den meisten Systemen eine der wenigen messbaren Zustandsgrößen ist, erlaubt diese eine gute und häufig die einzige Aussage über das Batterieverhalten bzw. die von einem System ausgegebenen Zustandsgrößen. Abweichungen vom simulierten Verhalten können zur Erkennung von Anomalien und akuten Modellverbesserungen genutzt werden, um zukünftige Prognosen zu optimieren. Das Vergleichen kann beispielsweise ein Bestimmen einer Korrelation, eines Bestimmtheitsmaßes, z.B. des Bestimmtheitsmaßes R², oder einer mittleren Abweichung umfassen.

Das jeweilige Modell kann anhand von Trainingsdaten trainiert werden. Das Simulationssystem kann dazu eingerichtet sein, das jeweilige Modell anhand von Trainingsdaten zu trainieren. Die Trainingsdaten für das jeweilige Modell umfassen mehrere Trainingssequenzen, wobei eine jeweilige Trainingssequenz einen gemessenen zeitlichen Verlauf von Strom und Spannung oder Leistung und Spannung der dem Modell zugeordneten Speichereinheit beschreibt. Beim Trainieren eines Modells anhand einer jeweiligen Trainingssequenz verarbeitet der Encoder eine Encoder-Eingabesequenz, die einem ersten Abschnitt der Trainingssequenz entspricht und einen gemessenen zeitlichen Verlauf von Strom und Spannung oder Leistung und Spannung der dem Modell zugeordneten Speichereinheit beschreibt. Der Decoder verarbeitet eine Decoder-Eingabesequenz, die einem zweiten Abschnitt der Trainingssequenz entspricht und einen gemessenen zeitlichen Verlauf des Stroms oder der Leistung der dem Modell zugeordneten Speichereinheit beschreibt. Die erzeugte Decoder-Ausgabesequenz beschreibt einen simulierten zeitlichen Verlauf der Spannung der dem Modell zugeordneten Speichereinheit. Anhand von Abweichungen der erzeugten Decoder-Ausgabesequenz von einem zeitlichen Verlauf der Spannung gemäß dem zweiten Abschnitt der Trainingssequenz wird dann das Modell angepasst. Auf diese Weise kann das Simulationssystem anhand von Messdaten der Speichereinheit(en) trainiert werden. Ein Auswerten der Abweichungen kann beispielsweise ein Evaluieren einer Modellgüte des Modells umfassen.

Für ein neu zu trainierendes Simulationssystem für mehrere Speichereinheiten kann beispielsweise zunächst ein allgemeines Modell für alle Speichereinheiten trainiert werden, und anschließend können ausgehend von dem trainierten allgemeinen Modell individuelle Modelle für die jeweiligen Speichereinheiten anhand von Messdaten der betreffenden Speichereinheiten trainiert werden. Diese können gegebenenfalls sogar im Betrieb des Simulationsverfahrens weiter trainiert werden. Nach einem Training besteht für jede Batterie, bzw. Zelle im System ein individuelles Modell.

In Ausführungsformen ist das Simulationssystem eingerichtet, das jeweilige Modell anhand von Trainingsdaten zu trainieren, wobei Trainingsdaten für das jeweilige Modell mehrere Trainingssequenzen umfassen, wobei eine jeweilige Trainingssequenz einen gemessenen zeitlichen Verlauf von Strom und Spannung oder Leistung und Spannung der dem Modell zugeordneten Speichereinheit beschreibt, wobei das Trainieren des jeweiligen Modells für eine jeweilige Trainingssequenz umfasst: Verarbeiten einer Encoder-Eingabesequenz durch den Encoder, wobei die Encoder-Eingabesequenz einem ersten Abschnitt der Trainingssequenz entspricht und einen gemessenen zeitlichen Verlauf von Strom und Spannung oder Leistung und Spannung der dem Modell zugeordneten Speichereinheit beschreibt, wobei das Verarbeiten der Encoder-Eingabesequenz umfasst, aus der Encoder-Eingabesequenz einen initialen Zustand des Modells zu erzeugen; ausgehend von dem initialen Zustand des Modells, Verarbeiten einer Decoder-Eingabesequenz durch den Decoder, wobei die Decoder-Eingabesequenz einem zweiten Abschnitt der Trainingssequenz entspricht und einen gemessenen zeitlichen Verlauf des Stroms oder der Leistung der dem Modell zugeordneten Speichereinheit beschreibt, wobei das Verarbeiten der Decoder-Eingabesequenz umfasst, ausgehend von dem initialen Zustand des Modells aus der Decoder-Eingabesequenz eine Decoder-Ausgabesequenz zu erzeugen, die einen simulierten zeitlichen Verlauf der Spannung der dem Modell zugeordneten Speichereinheit beschreibt; und Anpassen des Modells basierend auf von Abweichungen der erzeugten Decoder-Ausgabesequenz von einem zeitlichen Verlauf der Spannung gemäß dem zweiten Abschnitt der Trainingssequenz.

Dies gestattet es, das Simulationssystem an einen sich ändernden Zustand der j eweiligen Speichereinheit des Energiespeichers anzupassen. Dazu umfassen die Trainingsdaten insbesondere neue Trainingssequenzen, wobei eine jeweilige neue Trainingssequenz einen neu gemessenen zeitlichen Verlauf von Strom und Spannung oder Leistung und Spannung der dem Modell zugeordneten Speichereinheit beschreibt. Dies gestattet es, das Simulationssystem im Falle einer Degradation des Energiespeichers anzupassen. Das System kann sich in seinen Analysefunktionen somit intelligent über die Lebensdauer des Systems an die an das Analysesystem gestellten Aufgaben anpassen. Es wird ein lernfähiges Simulationssystem ermöglicht: Fehler in der Vorhersage können durch Weiterlernen (Trainieren) des Modells zu präzisieren Modellen und einer verbesserten Vorhersage der Spannung und Prognose der Zustandsgrößen der Batterie führen.

Das Simulationssystem kann einfach in bestehende Energiespeicher-Managementsysteme nachgerüstet werden, da einzig historische Daten nötig sind.

Gemäß einer Weiterbildung der Erfindung wird die Aufgabe gelöst durch ein Energiespeicher-Managementsystem für einen Energiespeicher mit wenigstens einer Speichereinheit, umfassend einen Datenspeicher zum Speichern eines jeweiligen gemessenen zeitlichen Verlaufs von Strom und Spannung oder Leistung und Spannung der jeweiligen Speichereinheit, wobei das Energiespeicher-Managementsystem weiter ein Simulationssystem wie oben beschrieben aufweist.

Das Energiespeicher-Managementsystem kann beispielsweise eine Messvorrichtung zum Messen von Strom und Spannung oder Leistung und Spannung der jeweiligen Speichereinheit des Energiespeichers umfassen, wobei das Energiespeicher-Managementsystem eingerichtet ist, jeweilige gemessene zeitliche Verläufe von Strom und Spannung oder Leistung und Spannung der jeweiligen Speichereinheit in dem Datenspeicher zu speichern. Der Datenspeicher kann beispielsweise eine Datenbank sein oder umfassen, in welcher der jeweilige gemessene zeitliche Verlaufs von Strom und Spannung oder Leistung und Spannung der jeweiligen Speichereinheit gespeichert wird.

Die Aufgabe wird weiter gelöst durch ein Verfahren zum Simulieren eines Leistungsverhaltens wenigstens einer Speichereinheit eines Energiespeichers durch ein Simulationssystem, das wenigstens ein jeweiliges Modell für eine dem Modell zugeordnete jeweilige Speichereinheit des Energiespeichers umfasst, wobei das Modell ein Encoder-Decoder-Modell mit einem Encoder und einem Decoder umfasst, wobei das Encoder-Decoder-Modell wenigstens ein rekurrentes neuronales Netzwerk oder wenigstens ein neuronales Netzwerk mit einer Transformer-Architektur umfasst, wobei das Verfahren die Schritte aufweist: Verarbeiten einer Encoder-Eingabesequenz durch den Encoder und Erzeugen eines initialen Zustands des Modells, wobei die Encoder-Eingabesequenz einen gemessenen zeitlichen Verlauf von Strom und Spannung oder Leistung und Spannung der dem Modell zugeordneten Speichereinheit beschreibt; und Verarbeiten einer Decoder-Eingabesequenz durch den Decoder und Erzeugen einer Decoder-Ausgabesequenz, wobei die Decoder-Eingabesequenz einen zu simulierenden zeitlichen Verlauf des Stroms oder der Leistung der dem Modell zugeordneten Speichereinheit beschreibt, und wobei die Decoder-Ausgabesequenz einen simulierten zeitlichen Verlauf der Spannung der dem Modell zugeordneten Speichereinheit beschreibt.

Das Verfahren kann die oben für das Simulationssystem beschriebenen Operationen als Verfahrensschritte umfassen, insbesondere Operationen des Encoders, des Decoders, und des Simulationssystems, wie z.B. das Prognostizieren, ob die jeweilige Speichereinheit des Energiespeichers ein Lastszenario erfüllen kann, mit den genannten Schritten des Verarbeitens und Überprüfens; das Schätzen eines Zustandsparameters, der einen Zustand der jeweiligen Speichereinheit des Energiespeichers kennzeichnet, mit den genannten Schritten des Verarbeitens und Bestimmen eines Schätzwertes; das Vergleichen eines simulierten zeitlichen Verlaufs der Spannung mit einem weiteren, gemessenen zeitlichen Verlauf der Spannung, und das Bestimmen eines Indikators für eine Güte des Modells; das Ausgeben der erwähnten Decoder-Ausgabesequenzen und/oder des davon beschriebenen zeitlichen Verlaufs der Spannung und/oder der weiteren genannten Ergebnisse, Prognosen, Schätzwerte, Indikatoren; das Trainieren des jeweiligen Modells anhand von Trainingsdaten, mit den genannten Schritten des Verarbeitens und Anpassen des Modells. Das Simulationssystem kann dem oben beschriebenen Simulationssystem entsprechen.

Bevorzugte Ausführungsbeispiele werden im Folgenden anhand der Zeichnung näher erläutert. Es zeigen:
- Fig. 1: eine schematische Darstellung eines Energiespeicher-Managementsystems mit einem Simulationssystem gemäß einer Ausführungsform;
- Fig. 2: eine schematische Darstellung der Verwendung von Trainingssequenzen zum Trainieren des Simulationssystems;
- Fig. 3: eine schematische Darstellung von Strom-Spannungs-Verläufen; und
- Fig. 4: eine schematische Darstellung von Strom-Spannungs-Verläufen und einer Simulationsgüte.

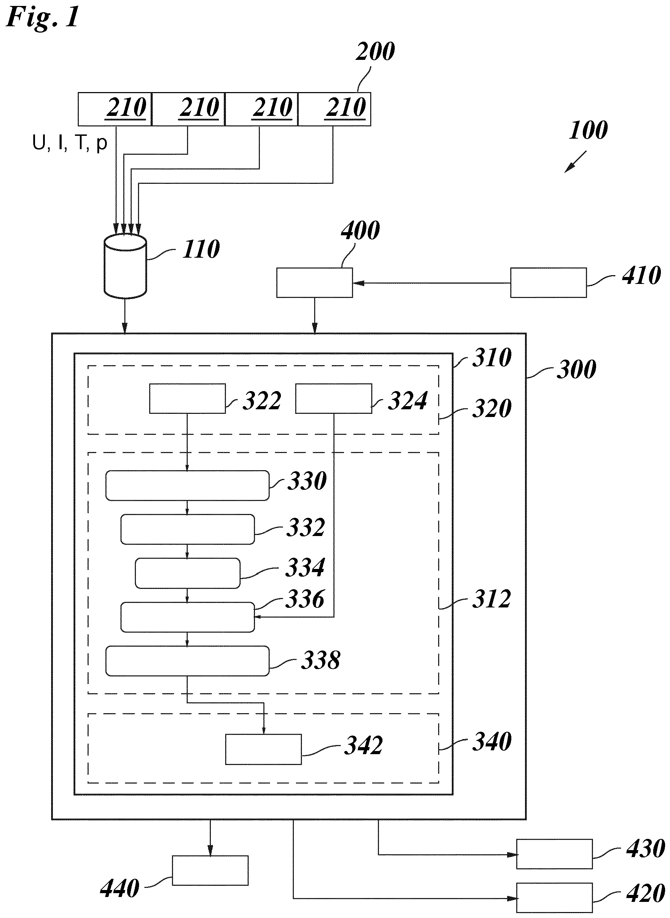

Fig. 1 zeigt schematisch ein Energiespeicher-Managementsystem 100 sowie einen elektrochemischen Energiespeicher 200 mit mehreren Speichereinheiten 210, bei denen es sich beispielsweise um Speicherzellen oder Speichermodule handelt. Das Energiespeicher-Managementsystem 100 umfasst einen Speicher 110 zum Speichern von gemessenen Werten einer Spannung U, eines Stroms I, einer Temperatur T und gegebenenfalls eines Drucks p der jeweiligen Speichereinheiten 210. Während nachfolgend die Verwendung von Werten des Stroms I beschrieben werden, beispielsweise für Eingabesequenzen und für zu simulierende Verläufe, ist die Erfindung nicht hierauf beschränkt. Es kann beispielsweise auch anstelle von Strom I die Leistung P verwendet werden.

Das Energiespeicher-Managementsystem 100 umfasst ein Simulationssystem 300, das für jede Speichereinheit 210 ein zugeordnetes Model 310 umfasst. Aus Gründen der Übersichtlichkeit ist in Fig. 1 exemplarisch ein Model 310 dargestellt.

Das Modell 310 umfasst ein Encoder-Decoder-Modell 312 zur Verarbeitung von Eingabesequenzen 320 oder Eingabevektoren, auch als Eingabe oder Input-Features bezeichnet. Das Encoder-Decoder-Modell 312 erzeugt Ausgabesequenzen 340 oder Ausgabevektoren, auch als Ausgabe oder Output Features bezeichnet. Das Encoder-Decoder-Modell 312 umfasst eine erste Encoder-Schicht 330 und eine zweite Encoder-Schicht 332, die durch Verarbeitung einer Encoder-Eingabesequenz 322 einen Modellzustand 334 erzeugen. Weiter umfasst das Modell 310 eine erste Decoder-Schicht 336 und eine zweite Decoder-Schicht 338. Die erste Decoder-Schicht 336 verarbeitet eine Decoder-Eingabesequenz 324. Die zweite Decoder-Schicht 338 erzeugt eine Decoder-Ausgangssequenz 342. Die Schichten 330, 332, 336, 338 sind beispielsweise rekurrente neuronale Netzwerke.

Die Encoder-Eingabesequenzen 322 beschreiben jeweils einen gemessenen zeitlichen Verlauf von Strom I und Spannung U der dem Modell 310 zugeordneten Speichereinheit 210 und werden beispielsweise aus den im Speicher 110 gespeicherten Messwerten ausgewählt und/oder interpoliert. Durch die Verarbeitung der Encoder-Eingabesequenz 322 wird ein initialer Modellzustand 334 erzeugt. Unter schrittweiser Verarbeitung der Encoder-Eingabesequenz 322 aktualisiert das Encoder-Decoder-Modell 312 schrittweise seinen Zustand. Das Modell 310 wird in den initialen Zustand 334 gebracht, der einem Zustand der zu simulierenden Speichereinheit 210 entspricht.

Je nach Anwendung beschreiben die Decoder-Eingabesequenzen 324 einen gemessenen zeitlichen Verlauf des Stroms I der dem Modell 310 zugeordneten Speichereinheit 210, oder einen zu simulierenden Verlauf 400 des Stroms I der dem Modell 310 zugeordneten Speichereinheit 210. Der zu simulierende Verlauf 400 des Stroms I kann beispielsweise durch ein als Eingabe in das Energiespeicher-Managementsystem 100 eingegebenes Lastszenario 410 definiert sein.

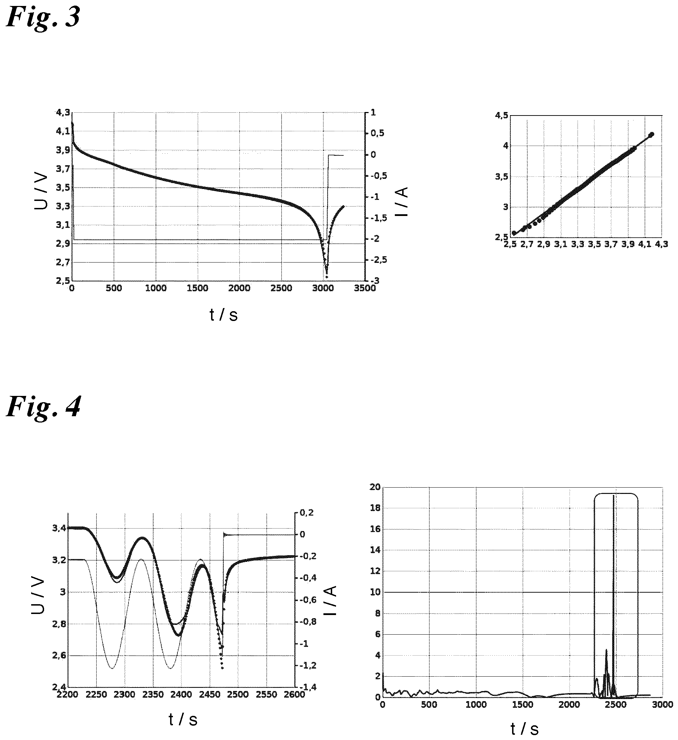

In einem Simulationslauf verarbeitet das Modell 310 die Decoder-Eingabesequenz 324 und erzeugt eine Decoder-Ausgangssequenz 342, wobei das Modell 310 anfänglich den initialen Zustand 334 hat. Es wird unter schrittweiser Verarbeitung der Decoder-Eingabesequenz 324 schrittweise die Decoder-Ausgangssequenz 342 erzeugt, wobei das Encoder-Decoder-Modell 312 schrittweise seinen Zustand aktualisiert, wobei in einem jeweiligen Schritt das Encoder-Decoder-Modell 312 einen Strom-Wert verarbeitet, das Encoder-Decoder-Modell 312 seinen Zustand aktualisiert und das Encoder-Decoder-Modell 312 einen Spannungs-Wert der Decoder-Ausgangssequenz 342 erzeugt. Dies ermöglicht es, bspw. eine Simulation für eine Entladung mit einem definierten Strom durchzuführen und daraus einen Wert für eben diese Entladung anzugeben (SoHic). Ein Beispiel dafür ist in Fig. 3 gezeigt.

Eine Ausgabe 340 des Modells 310 kann je nach Anwendung beispielsweise einen Schätzwert 420 für einen Zustandsparameter einer jeweiligen Speichereinheit 210 oder des Energiespeichers 200 umfassen, oder eine Prognose 430 über die Erfüllbarkeit des Lastszenarios 410 durch die jeweilige Speichereinheit 210 bzw. durch den Energiespeicher 200 im gegenwärtigen Zustand. Als ausgegebene Spannungswerte der Ausgabe 340 können auch Mittelwerte und Standardabweichung der Spannung vorgesehen sein. Weiter kann eine Ausgabe 340 einen Indikator 440 für eine Güte des jeweiligen Modells 310 umfassen. Über eine Korrelation der simulierten und im Anschluss tatsächlich gemessenen Werte ist es möglich, die Modellgüte zu evaluieren. Dies kann bspw. über eine Korrelation, das Bestimmtheitsmaß R² oder die mittlere Abweichung geschehen. Durch eine Betrachtung des Fehlers ist es außerdem möglich, Schwächen des Modells 310 zu evaluieren und geschätzte Unsicherheiten für die simulierten Werte anzugeben. Dies ist beispielhaft in den Diagrammen der Fig. 4 dargestellt.

Die jeweiligen Eingabesequenzen 320 können außer den Werten für den Strom I bzw. Strom I und Spannung U zusätzlich auch einen Verlauf der Temperatur T und gegebenenfalls einen Verlauf des mechanischen Drucks p für die jeweilige Speichereinheit 210 beschreiben. Entsprechend kann auch ein jeweiliger simulierter Verlauf 400 bzw. ein Lastszenario 410 auch Werte für Temperatur T und/oder Druck p umfassen.

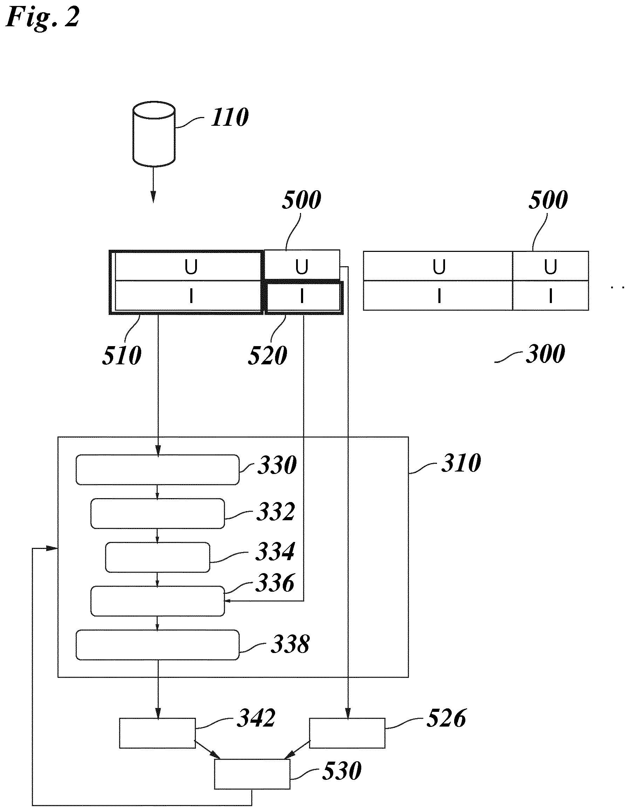

In einem ersten Schritt wird das jeweilige Modell 310 auf die entsprechende Speichereinheit 210 oder Speicherzelle trainiert. Dazu werden historische Daten von Spannung U, Temperatur T, Strom I und Druck p verwendet. Fig. 2 zeigt schematisch die Verwendung von Trainingssequenzen 500, basierend auf den gespeicherten gemessenen Daten des Speichers 110. Hier sind exemplarisch nur Spannung U und Strom I dargestellt; Temperatur T und/oder Druck p können in gleicher Weise wie der Strom I behandelt werden. Die jeweilige Trainingssequenz 500 wird in einen ersten Abschnitt 510 und einen zweiten Abschnitt 520 aufgeteilt. Eine Encoder-Eingabesequenz 322 entspricht dem ersten Abschnitt 510 und beschreibt insbesondere den gemessenen zeitlichen Verlauf von Strom I und Spannung U des ersten Abschnitts 510. Der Encoder/Decoder-Ansatz ermittelt dabei den initialen Zustand 334 (Battery State) der Batterie aus bspw. den Daten (Spannung U, Strom I und Temperatur T, ggf. Druck p) der vergangenen 60 Minuten, entsprechend dem ersten Abschnitt 510. Der initiale Zustand 334 wird dabei über eine mathematische Repräsentation (entsprechend einer Matrix oder einem Vektor mit vielen Werten) dargestellt, die nicht notwendigerweise physikalisch interpretierbar ist. Dieser Zustand 344 kann bspw. durch rekursive neuronale Netze (RNN) wie z.B. LSTM, GRU etc. der Schichten 330, 332 gefunden oder optimiert werden.

Anschließend wird dieser initiale Zustand 334 als Eingangswert für den Decoder 336, 338 (wieder in Form von RNN) genutzt, der der anhand des internen Zustands und des zu erwartenden Strom- bzw. Temperaturprofils gemäß einer Decoder-Eingabesequenz 324 das resultierende Spannungsprofil simuliert. Die Decoder-Eingabesequenz 324 wird aus dem zweiten Abschnitt 520 der Trainingssequenz 500 gewonnen und beschreibt den gemessenen zeitlichen Verlauf des Stroms I im zweiten Abschnitt 520 (sowie ggf. Temperatur T, Druck p). Eine Vergleichssequenz 526 wird aus dem zweiten Abschnitt 520 gewonnen und beschreibt den gemessenen zeitlichen Verlauf der Spannung U im zweiten Abschnitt 520. Die Vergleichssequenz wird mit der vom Modell 310 erzeugten Ausgabesequenz 342 durch eine Rückkopplungseinheit 530 verglichen, und entsprechend der festgestellten Abweichung wird das Modell 310 angepasst.

Das trainierte Simulationssystem 300 kann beispielsweise zur Schätzung einer Zustandsgröße der Speichereinheit 210 eingesetzt werden. Fig. 3 zeigt im linken Teil beispielhaft und schematisch einen zeitlichen Verlauf eines Stroms I (als dünne Linie), einer gemessenen Spannung U (als Punkte) und einer simulierten Spannung U (als dicke Linie) für eine Speichereinheit 210. Im Beispiel der Figur 3 wird eine Entladung mit einem definierten Strom von 2 A simuliert. Sowohl die gemessene Spannung als auch die simulierte Spannung sinken im Laufe der Zeit und unterschreiten schließlich die Entladeschlussspannung. Daraus kann das Simulationssystem 300 beispielsweise einen Zustandsparameter SoHic bestimmen.

Weiter ist es möglich, jedes Modell 310 fortlaufend auf den (neu) gemessenen Daten seiner entsprechenden Zelle oder Speichereinheit 210 zu trainieren. Es ergibt sich somit ein präzises digitales Abbild dieser Zelle oder Speichereinheit 210, anhand dessen genaue Modellvorhersagen und somit eine Aussage über den individuellen gewünschten Batteriezustand gemacht werden kann. Durch das erlangte Wissen hat ein Anwender nun die Möglichkeit, Betriebsstrategien und Wartungsintervalle dem Batterie- und Systemzustand anzupassen und aktiv auf Abweichungen vom erwarteten Verhalten zu reagieren.

Im rechten Teil der Fig. 3 ist schematisch über der gemessenen Spannung in Volt sowohl die gemessene Spannung (mit einer durchgezogenen Linie) in Volt als auch die simulierte Spannung (mit Punkten) in Volt dargestellt. Es zeigt sich eine gute Übereinstimmung.

Fig. 4 zeigt schematisch in einem linken Teil eine Darstellung von Strom- und Spannungsverläufen entsprechend der Darstellung der Fig. 3 für ein Beispiel eines Lastszenarios mit variierendem Strom I. Im rechten Teil von Fig. 4 ist in mV ein zeitlicher Verlauf des relativen Fehlers der simulierten Spannung gegenüber der gemessenen Spannung dargestellt. Das Vergleichsergebnis erlaubt es, Rückschlüsse auf die Güte des Modells 310 zu treffen und das Modell 310 gezielt in festgestellten Regionen höherer Abweichung zu trainieren. Durch gezieltes Training in diesen Regionen höherer Abweichung kann ein Fehler dort minimiert werden.

## Patentansprüche

1. Simulationssystem zum Simulieren eines Leistungsverhaltens wenigstens einer Speichereinheit (210) eines Energiespeichers (200), wobei das Simulationssystem aufweist:
wenigstens ein jeweiliges Modell (320) für eine dem Modell (310) zugeordnete jeweilige Speichereinheit (210) des Energiespeichers (200), wobei das Modell (320) ein Encoder-Decoder-Modell mit einem Encoder (330, 332) und einem Decoder (336, 338) umfasst, wobei das Encoder-Decoder-Modell wenigstens ein rekurrentes neuronales Netzwerk oder wenigstens ein neuronales Netzwerk mit einer Transformer-Architektur umfasst,
wobei der Encoder (330, 332) dazu eingerichtet ist, eine Encoder-Eingabesequenz (322) zu verarbeiten, die einen gemessenen zeitlichen Verlauf von Strom (I) und Spannung (U) oder Leistung (P) und Spannung (U) der dem Modell (310) zugeordneten Speichereinheit (210) beschreibt, wobei das Verarbeiten der Encoder-Eingabesequenz (322) umfasst, aus der Encoder-Eingabesequenz (322) einen initialen Zustand (334) des Modells (310) zu erzeugen, und
wobei der Decoder (336, 338) dazu eingerichtet ist, ausgehend von dem initialen Zustand (334) des Modells (310) eine Decoder-Eingabesequenz (324) zu verarbeiten, die einen zu simulierenden zeitlichen Verlauf des Stroms (I) oder der Leistung (P) der dem Modell (310) zugeordneten Speichereinheit (210) beschreibt, wobei das Verarbeiten der Decoder-Eingabesequenz (324) umfasst, ausgehend von dem initialen Zustand des Modells (334) aus der Decoder-Eingabesequenz (324) eine Decoder-Ausgabesequenz (342) zu erzeugen, die einen simulierten zeitlichen Verlauf der Spannung (U) der dem Modell (310) zugeordneten Speichereinheit (210) beschreibt.

2. Simulationssystem nach Anspruch 1, wobei die Encoder-Eingabesequenz (322) den gemessenen zeitlichen Verlauf von Strom (I) und Spannung (U) oder Leistung (P) und Spannung (U) der dem Modell (310) zugeordneten Speichereinheit (210) und einen gemessenen zeitlichen Verlauf einer Temperatur (T) beschreibt, und wobei die Decoder-Eingabesequenz (324) den zu simulierenden zeitlichen Verlauf des Stroms (I) oder der Leistung (P) der dem Modell (320) zugeordneten Speichereinheit (210) und einen zu simulierenden zeitlichen Verlauf einer Temperatur (T) beschreibt.

3. Simulationssystem nach Anspruch 1 oder 2, wobei der jeweilige Encoder (330, 332) und/oder der jeweilige Decoder (336, 338) ein rekurrentes neuronales Netzwerk mit einer LSTM-Architektur oder einer GRU-Architektur ist, oder ein Convolutional Neural Network, CNN.

4. Simulationssystem nach einem der vorstehenden Ansprüche, wobei das Simulationssystem (300) eingerichtet ist, zu prognostizieren, ob die jeweilige Speichereinheit (210) des Energiespeichers (200) ein Lastszenario (410) erfüllen kann, wobei das Prognostizieren umfasst:
Verarbeiten einer jeweiligen Encoder-Eingabesequenz (322) durch den Encoder (330, 332) des Modells (310), dem die jeweilige Speichereinheit (210) zugeordnet ist, wobei die Encoder-Eingabesequenz (322) einen zuletzt gemessenen zeitlichen Verlauf von Strom (I) und Spannung (U) oder Leistung (P) und Spannung (U) der dem Modell (310) zugeordneten Speichereinheit (210) beschreibt, wobei das Verarbeiten der Encoder-Eingabesequenz (322) umfasst, aus der Encoder-Eingabesequenz (322) einen initialen Zustand (334) des Modells (310) zu erzeugen; und,
ausgehend von dem initialen Zustand (334) des Modells, Verarbeiten einer jeweiligen Decoder-Eingabesequenz (324) durch den Decoder (336, 338) des Modells, dem die jeweilige Speichereinheit zugeordnet ist, wobei die Decoder-Eingabesequenz (324) einen zu simulierenden zeitlichen Verlauf des Stroms (I) oder der Leistung (P) der dem Modell zugeordneten Speichereinheit gemäß dem Lastszenario (410) beschreibt, wobei das Verarbeiten der Decoder-Eingabesequenz (324) umfasst, ausgehend von dem initialen Zustand (334) des Modells aus der Decoder-Eingabesequenz (324) eine Decoder-Ausgabesequenz (342) zu erzeugen, die einen simulierten zeitlichen Verlauf der Spannung (U) der dem Modell zugeordneten Speichereinheit beschreibt; und
Überprüfen, ob die erzeugte Decoder-Ausgabesequenz (342) das Lastszenario (410) erfüllt, und wenn dies der Fall ist, Prognostizieren, dass das Lastszenario (410) erfüllt werden kann, und sonst, Prognostizieren, dass das Lastszenario (410) nicht erfüllt werden kann.

5. Simulationssystem nach einem der vorstehenden Ansprüche, wobei das Simulationssystem (300) eingerichtet ist, einen Zustandsparameter zu schätzen, der einen Zustand der jeweiligen Speichereinheit (210) des Energiespeichers (200) kennzeichnet, wobei das Schätzen des Zustandsparameters umfasst:
Verarbeiten einer jeweiligen Encoder-Eingabesequenz (322) durch den Encoder (330, 332) des Modells, dem die jeweilige Speichereinheit zugeordnet ist, wobei die Encoder-Eingabesequenz (322) einen zuletzt gemessenen zeitlichen Verlauf von Strom (I) und Spannung (U) oder Leistung (P) und Spannung (U) der dem Modell zugeordneten Speichereinheit beschreibt, wobei das Verarbeiten der Encoder-Eingabesequenz (322) umfasst, aus der Encoder-Eingabesequenz (322) einen initialen Zustand (334) des Modells zu erzeugen; und,
ausgehend von dem initialen Zustand (334) des Modells, Verarbeiten einer jeweiligen Decoder-Eingabesequenz (324) durch den Decoder (336, 338) des Modells, dem die jeweilige Speichereinheit zugeordnet ist, wobei die Decoder-Eingabesequenz (324) einen zu simulierenden zeitlichen Verlauf des Stroms (I) oder der Leistung (P) der dem Modell zugeordneten Speichereinheit beschreibt, wobei das Verarbeiten der Decoder-Eingabesequenz (324) umfasst, ausgehend von dem initialen Zustand (334) des Modells aus der Decoder-Eingabesequenz (324) eine Decoder-Ausgabesequenz (342) zu erzeugen, die einen simulierten zeitlichen Verlauf der Spannung (U) der dem Modell zugeordneten Speichereinheit beschreibt; und
Bestimmen eines Schätzwertes (420) für den Zustandsparameter anhand des zu simulierenden zeitlichen Verlaufs des Stroms (I) oder der Leistung (P) und des zugehörigen simulierten Verlaufs der Spannung (U).

6. Simulationssystem nach einem der vorstehenden Ansprüche, wobei das Simulationssystem (300) eingerichtet ist, den simulierten zeitlichen Verlauf der Spannung (U) mit einem weiteren, gemessenen zeitlichen Verlauf der Spannung (U) der dem Modell (310) zugeordneten Speichereinheit (210) zu vergleichen und aus dem Vergleichsergebnis einen Indikator (440) für eine Güte des Modells (310) zu bestimmen.

7. Simulationssystem nach einem der vorstehenden Ansprüche, wobei das Simulationssystem (300) eingerichtet ist, das jeweilige Modell (310) anhand von Trainingsdaten zu trainieren, wobei Trainingsdaten für das jeweilige Modell mehrere Trainingssequenzen (500) umfassen, wobei eine jeweilige Trainingssequenz (500) einen gemessenen zeitlichen Verlauf von Strom (I) und Spannung (U) oder Leistung (P) und Spannung (U) der dem Modell zugeordneten Speichereinheit (210) beschreibt, wobei das Trainieren des jeweiligen Modells (310) für eine jeweilige Trainingssequenz (500) umfasst:
Verarbeiten einer Encoder-Eingabesequenz (322) durch den Encoder (330, 332), wobei die Encoder-Eingabesequenz (322) einem ersten Abschnitt (510) der Trainingssequenz (500) entspricht und einen gemessenen zeitlichen Verlauf von Strom (I) und Spannung (U) oder Leistung (P) und Spannung (U) der dem Modell zugeordneten Speichereinheit beschreibt, wobei das Verarbeiten der Encoder-Eingabesequenz (322) umfasst, aus der Encoder-Eingabesequenz (322) einen initialen Zustand (334) des Modells zu erzeugen;
ausgehend von dem initialen Zustand (334) des Modells, Verarbeiten einer Decoder-Eingabesequenz (324) durch den Decoder (336, 338), wobei die Decoder-Eingabesequenz (324) einem zweiten Abschnitt (520) der Trainingssequenz (500) entspricht und einen gemessenen zeitlichen Verlauf des Stroms (I) oder der Leistung (P) der dem Modell zugeordneten Speichereinheit beschreibt, wobei das Verarbeiten der Decoder-Eingabesequenz (324) umfasst, ausgehend von dem initialen Zustand (334) des Modells aus der Decoder-Eingabesequenz (324) eine Decoder-Ausgabesequenz (342) zu erzeugen, die einen simulierten zeitlichen Verlauf der Spannung (U) der dem Modell zugeordneten Speichereinheit (210) beschreibt; und
Anpassen des Modells (310) basierend auf von Abweichungen der erzeugten Decoder-Ausgabesequenz (342) von einem zeitlichen Verlauf der Spannung (U) gemäß dem zweiten Abschnitt (520) der Trainingssequenz (500).

8. Energiespeicher-Managementsystem für einen Energiespeicher (200) mit wenigstens einer Speichereinheit (210), umfassend einen Datenspeicher (110) zum Speichern eines jeweiligen gemessenen zeitlichen Verlaufs von Strom (I) und Spannung (U) oder Leistung (P) und Spannung (U) der jeweiligen Speichereinheit (210),
**dadurch gekennzeichnet, dass** das Energiespeicher-Managementsystem (100) weiter ein Simulationssystem (300) nach einem der Ansprüche 1 bis 7 zum Simulieren eines Leistungsverhaltens der jeweiligen Speichereinheit (210) des Energiespeichers (200) aufweist.

9. Verfahren zum Simulieren eines Leistungsverhaltens wenigstens einer Speichereinheit (210) eines Energiespeichers (200) durch ein Simulationssystem (300), das wenigstens ein jeweiliges Modell (310) für eine dem Modell zugeordnete jeweilige Speichereinheit (210) des Energiespeichers umfasst, wobei das Modell (310) ein Encoder-Decoder-Modell mit einem Encoder (330, 332) und einem Decoder (336, 338) umfasst, wobei das Encoder-Decoder-Modell wenigstens ein rekurrentes neuronales Netzwerk oder wenigstens ein neuronales Netzwerk mit einer Transformer-Architektur umfasst, wobei das Verfahren die Schritte aufweist:
Verarbeiten einer Encoder-Eingabesequenz (322) durch den Encoder und Erzeugen eines initialen Zustands (334) des Modells (310), wobei die Encoder-Eingabesequenz (322) einen gemessenen zeitlichen Verlauf von Strom (I) und Spannung (U) oder Leistung (P) und Spannung (U) der dem Modell zugeordneten Speichereinheit (210) beschreibt; und
Verarbeiten einer Decoder-Eingabesequenz (324) durch den Decoder (336, 338) und Erzeugen einer Decoder-Ausgabesequenz (342), wobei die Decoder-Eingabesequenz (324) einen zu simulierenden zeitlichen Verlauf des Stroms (I) oder der Leistung (P) der dem Modell zugeordneten Speichereinheit beschreibt, und wobei die Decoder-Ausgabesequenz (342) einen simulierten zeitlichen Verlauf der Spannung (U) der dem Modell zugeordneten Speichereinheit beschreibt.

## Claims

1. A simulation system for simulating a performance of at least one storage unit (210) of an energy storage (200), wherein the simulation system comprises:
at least a respective model (310) for a respective storage unit (210) of the energy storage (200), the storage unit (210) being assigned to the model (310), wherein the model (310) includes an encoder-decoder model having an encoder (330, 332) and a decoder (336, 338), wherein the encoder-decoder model includes at least one recurrent neural network or at least one neural network having a transformer architecture,
wherein the encoder (330, 332) is configured for processing an encoder input sequence (322) that describes a measured temporal course of current (I) and voltage (U), or of power (P) and voltage (U) of the storage unit (210) that is assigned to the model (310), wherein the processing of the encoder input sequence (322) includes generating an initial state (334) of the model (310) from the encoder input sequence (322), and
wherein the decoder (336, 338) is configured for processing a decoder input sequence (324) while starting from the initial state of the model (310), the decoder input sequence (324) describing a temporal course that is to be simulated of the current (I) or of the power (P) of the storage unit (210) that is assigned to the model (310), wherein the processing of the decoder input sequence (324) includes generating a decoder output sequence (342) from the decoder input sequence (324) while starting from the initial state of the model (310), the decoder output sequence (342) describing a simulated temporal course of the voltage (U) of the storage unit (210) that is assigned to the model (310).

2. A simulation system according to claim 1, wherein the encoder input sequence (322) describes the measured temporal course of current (I) and voltage (U) or of power (P) and voltage (U) of the storage unit (210) assigned to the model (310) and a measured temporal course of a temperature (T), and wherein the decoder input sequence (324) describes the temporal course to be simulated of the current (I) or of the power (P) of the storage unit (210) assigned to the model (320) and a temporal course to be simulated of a temperature (T).

3. The simulation system according to claim 1 or 2, wherein the respective encoder (330, 332) and/or the respective decoder (336, 338) is a recurrent neural network having an LSTM architecture or a GRU architecture, or is a Convolutional Neural Network, CNN.

4. The simulation system according to one of the preceding claims, wherein the simulation system (300) is configured for predicting whether the respective storage unit (210) of the energy storage (200) can fulfill a load scenario (410), wherein the predicting comprises:
processing a respective encoder input sequence (322) by the encoder (330, 332) of the model (310) to which the respective storage unit (210) is assigned, wherein the encoder input sequence (322) describes a last measured temporal course of current (I) and voltage (U) or of power (P) and voltage (U) of the storage unit (210) assigned to the model (310), wherein the processing of the encoder input sequence (322) comprises generating an initial state (334) of the model (310) from the encoder input sequence (322); and,
starting from the initial state (334) of the model, processing a respective decoder input sequence (324) by the decoder (336, 338) of the model, to which the respective storage unit is assigned, wherein the decoder input sequence (324) in accordance with the load scenario (410) describes a temporal course to be simulated of the current (I) or of the power (P) of the storage unit assigned to the model, wherein the processing of the decoder input sequence (324) comprises, while starting from the initial state (334) of the model, generating a decoder output sequence (342) from the decoder input sequence (324), wherein the decoder output sequence (342) describes a simulated temporal course of the voltage (U) of the storage unit assigned to the model; and
checking whether the generated decoder output sequence (342) fulfills the load scenario (410), and if this is the case, predicting that the load scenario (410) can be fulfilled, and otherwise predicting that the load scenario (410) cannot be fulfilled.

5. The simulation system according to one of the preceding claims, wherein the simulation system (300) is configured for estimating a state parameter that indicates a state of the respective storage unit (210) of the energy storage (200), wherein the estimating of the state parameter includes:
processing a respective encoder input sequence (322) by the encoder (330, 332) of the model to which the respective storage unit is assigned, wherein the encoder input sequence (322) describes a last measured temporal course of current (I) and voltage (U) or of power (P) and voltage (U) of the storage unit assigned to the model, wherein the processing of the encoder input sequence (322) includes generating an initial state (334) of the model from the encoder input sequence (322); and,
starting from the initial state (334) of the model, processing a respective decoder input sequence (324) by the decoder (336, 338) of the model to which the respective storage (400) is assigned, wherein the decoder input sequence (324) describes a temporal course to be simulated of the current (I) or of the power (P) of the storage unit assigned to the model, wherein the processing of the decoder input sequence (324) includes, while starting from the initial state (334) of the model, generating a decoder output sequence (342) from the decoder input sequence (324), wherein the decoder output sequence (342) describes a simulated temporal course of the voltage (U) of the storage unit assigned to the model; and
determining an estimated value (420) of the state parameter on the basis of the temporal course to be simulated of the current (I) or of the power (P) and based on the associated simulated course of the voltage (U).

6. The simulation system according to one of the preceding claims, wherein the simulation system (300) is configured for comparing the simulated temporal course of the voltage (U) to a further measured temporal course of the voltage (U) of the storage unit (210) assigned to the model (310), and for determining an indicator (440) of a rating of the model (310) from the result of the comparison.

7. The simulation system according to one of the preceding claims, wherein the simulation system (300) is configured for training the respective model (310) on the basis of training data, wherein training data for the respective model include multiple training sequences (500), wherein a respective training sequence (500) describes a measured temporal course of current (I) and voltage (U) or of power (P) and voltage (U) of the storage unit (210) assigned to the model, wherein the training of the respective model (310) comprises, for a respective training sequence (500):
processing an encoder input sequence (322) by the encoder (330, 332), wherein the encoder input sequence (322) corresponds to a first section (510) of the training sequence (500) and describes a measured temporal course of current (I) and voltage (U) or of power (P) and voltage (U) of the storage unit assigned to the model, wherein the processing of the encoder input sequence (322) includes generating an initial state (334) of the model from the encoder input sequence (322);
starting from the initial state (334) of the model, processing a decoder input sequence (324) by the decoder (336, 338), wherein the decoder input sequence (324) corresponds to a second section (520) of the training sequence (500) and describes a measured temporal course of the current (I) or of the power (P) of the storage unit assigned to the model, wherein the processing of the decoder input sequence (324) includes, while starting from the initial state (334) of the model, generating a decoder output sequence (342) from the decoder input sequence (324), wherein the decoder output sequence describes a simulated temporal course of the voltage (U) of the storage unit (210) assigned to the model; and
adapting the model (310) based on deviations of the generated decoder output sequence (342) from a temporal course of the voltage (U) according to the second section (520) of the training sequence (500).

8. An energy storage management system for an energy storage (200) having at least one storage unit (210), the system comprising a data storage (110) for storing a respective measured temporal course of current (I) and voltage (U) or of power (P) and voltage (U) of the respective storage unit (210),
**characterized in that** the energy storage management system (100) further comprises a simulation system (300) according to anyone of the claims 1 to 7 for simulating a performance of the respective storage unit (210) of the energy storage (200).

9. A method for simulating a performance of at least one storage unit (210) of an energy storage (200) by a simulation system (300) that includes at least a respective model (310) for a respective storage unit (210) of the energy storage, the storage unit (210) being assigned to the model, wherein the model (310) includes an encoder-decoder model having an encoder (330, 332) and a decoder (336, 338), wherein the encoder-decoder model includes at least one recurrent neural network or at least one neural network having a transformer architecture, wherein the method includes the steps of:
processing an encoder input sequence (322) by the encoder and generating an initial state (334) of the model (310), wherein the encoder input sequence (322) describes a measured temporal course of current (I) and voltage (U) or of power (P) and voltage (U) of the storage unit (210) assigned to the model; and
processing a decoder input sequence (324) by the decoder (336, 338) and generating a decoder output sequence (342), wherein the decoder input sequence (324) describes a temporal course to be simulated of the current (I) or of the power (P) of the storage unit assigned to the model, and wherein the decoder output sequence (342) describes a simulated temporal course of the voltage (U) of the storage unit assigned to the model.

## Revendications

1. Système de simulation pour la simulation des performances d'au moins une unité d'accumulation (210) d'un accumulateur d'énergie (200), dans lequel le système de simulation comprend :
au moins un modèle (320) correspondant pour une unité d'accumulation (210) respective de l'accumulateur d'énergie (200) correspondant au modèle (320), dans lequel le modèle (320) comprend un modèle de codeur-décodeur avec un codeur (330, 332) et un décodeur (336, 338), dans lequel le modèle de codeur-décodeur comprend au moins un réseau neuronal récurrent ou au moins un réseau neuronal avec une architecture de transformateur,
dans lequel le codeur (330, 332) est conçu pour traiter une séquence d'entrée de codeur (322) qui décrit un tracé temporal mesuré du courant (I) et de la tension (U) ou de la puissance (P) et de la tension (U) de l'unité d'accumulation (210) correspondant au modèle (310), dans lequel le traitement de la séquence d'entrée du codeur (322) comprend la génération, à partir de la séquence d'entrée du codeur (322), d'un état initial (334) du modèle (310) et
dans lequel le décodeur (336, 338) est conçu pour traiter, à partir de l'état initial (334) du modèle (310), une séquence d'entrée du décodeur (324), qui décrit un tracé temporel à simuler du courant (I) ou de la puissance (P) de l'unité d'accumulation (210) correspondant au modèle (310), dans lequel le traitement de la séquence d'entrée du décodeur (324) comprend la génération, à partir de l'état initial du modèle (334), à partir de la séquence d'entrée du décodeur (324), une séquence de sortie du décodeur (342) qui décrit un tracé temporel simulé de la tension (U) de l'unité d'accumulation (210) correspondant au modèle (310).

2. Système de simulation selon la revendication 1, dans lequel la séquence d'entrée du codeur (322) décrit le tracé temporel mesuré du courant (I) et de la tension (U) ou de la puissance (P) et de la tension (U) de l'unité d'accumulation (210) correspondant au modèle (310) et un tracé temporel mesuré d'une température (T) et dans lequel la séquence d'entrée du décodeur (324) décrit le tracé temporel à simuler du courant (I) ou de la puissance (P) de l'unité d'accumulation (210) correspondant au modèle (320) et un tracé temporel à simuler d'une température (T).

3. Système de simulation selon la revendication 1 ou 2, dans lequel le codeur (330, 332) respectif et/ou le décodeur (336, 338) respectif est un réseau neuronal récurrent avec une architecture LSTMou une architecture GRU ou un Convolutional Neural Network CNN.

4. Système de simulation selon l'une des revendications précédentes, dans lequel le système de simulation (300) est conçu pour pronostiquer si l'unité d'accumulation (210) respective de l'accumulateur d'énergie (200) peut exécuter un scénario de charge (410), dans lequel le pronostic comprend :
le traitement d'une séquence d'entrée de codeur (322) respective par le codeur (330, 332) du modèle (310) auquel correspond l'unité d'accumulation (210) respective, dans lequel la séquence d'entrée du codeur (322) décrit le dernier tracé temporel mesuré du courant (I) et de la tension (U) ou de la puissance (P) et de la tension (U) de l'unité d'accumulation (210) correspondant au modèle (310), dans lequel le traitement de la séquence d'entrée du codeur (322) comprend la génération, à partir de la séquence d'entrée du codeur (322), d'un état initial (334) du modèle (310) ; et
à partir de l'état initial (334) du modèle, le traitement d'une séquence d'entrée du décodeur (324) par le décodeur (336, 338) du modèle auquel correspond l'unité d'accumulation respective, dans lequel la séquence d'entrée du décodeur (324) décrit un tracé temporel à simuler du courant (I) ou de la puissance (P) de l'unité d'accumulation correspondant au modèle selon le scénario de charge (410), dans lequel le traitement de la séquence d'entrée du décodeur (324) comprend la génération, à partir de l'état initial (334) du modèle, à partir de la séquence d'entrée du décodeur (324), une séquence de sortie du décodeur (342), qui décrit un tracé temporel simulé de la tension (U) de l'unité d'accumulation correspondant au modèle ; et
la vérification si la séquence de sortie du décodeur (342) exécute le scénario de charge (410) et, lorsque cela est le cas, le pronostic que le scénario de charge (410) peut être exécuté, sinon le pronostic que le scénario de charge (410) ne peut pas être exécuté.

5. Système de simulation selon l'une des revendications précédentes, dans lequel le système de simulation (300) est conçu pour évaluer un paramètre d'état qui caractérise un état de l'unité d'accumulation (210) respective de l'accumulateur d'énergie (200), dans lequel l'évaluation du paramètre d'état comprend :
le traitement d'une séquence d'entrée du codeur (322) respective par le codeur (330, 332) du modèle auquel correspondant l'unité d'accumulation respective, dans lequel la séquence d'entrée du codeur (322) décrit un dernier tracé temporel mesuré du courant (I) et de la tension (U) ou de la puissance (P) et de la tension (U) de l'unité d'accumulation correspondant au modèle, dans lequel le traitement de la séquence d'entrée du codeur (322) comprend la génération, à partir de la séquence d'entrée du codeur (322), d'un état initial (334) du modèle ; et
à partir de l'état initial (334) du modèle, le traitement d'une séquence d'entrée du décodeur (324) par le décodeur (336, 338) du modèle auquel correspond l'unité d'accumulation respective, dans lequel la séquence d'entrée du décodeur (324) décrit un tracé temporel à simuler du courant (I) ou de la puissance (P) de l'unité d'accumulation correspondant au modèle, dans lequel le traitement de la séquence d'entrée du décodeur (324) comprend la génération, à partir de l'état initial (334) du modèle, à partir de la séquence d'entrée du décodeur (324), une séquence de sortie du décodeur (342), qui décrit un tracé temporel simulé de la tension (U) de l'unité d'accumulation correspondant au modèle ; et
la détermination d'une valeur estimée (420) pour le paramètre d'état à l'aide du tracé temporel à simuler du courant (I) ou de la puissance (P) et du tracé simulé correspondant de la tension (U).

6. Système de simulation selon l'une des revendications précédentes, dans lequel le système de simulation (300) est conçu pour comparer le tracé temporel simulé de la tension (U) avec un autre tracé temporel mesuré de la tension (U) de l'unité d'accumulation (210) correspondant au modèle (310) et pour déterminer, à partir du résultat de la comparaison, un indicateur (440) pour une qualité du modèle (310).

7. Système de simulation selon l'une des revendications précédentes, dans lequel le système de simulation (300) est conçu pour entraîner le modèle (310) respectif à l'aide de données d'entraînement, dans lequel les données d'entraînement pour le modèle respectif comprennent plusieurs séquences d'entraînement (500), dans lequel une séquence d'entraînement (500) respective décrit un tracé temporel mesuré du courant (I) et de la tension (U) ou de la puissance (P) et de la tension (U) de l'unité d'accumulation (210) correspondant au modèle, dans lequel l'entraînement du modèle (310) respectif pour une séquence d'entraînement (500) respective comprend :
le traitement de la séquence d'entrée du codeur (322) par le codeur (330, 332), dans lequel la séquence d'entrée du codeur (322) correspond à une première portion (510) de la séquence d'entraînement (500) et décrit un tracé temporel mesuré du courant (I) et de la tension (U) ou de la puissance (P) et de la tension (U) de l'unité d'accumulation correspondant au modèle, dans lequel le traitement de la séquence d'entrée du codeur (322) comprend la génération, à partir de séquence d'entrée du codeur (322), d'un état initial (334) du modèle ;
à partir de l'état initial (334) du modèle, le traitement d'une séquence d'entrée du décodeur (324) par le décodeur (336, 338), dans lequel la séquence d'entrée du décodeur (324) correspond à une deuxième portion (520) de la séquence d'entraînement (500) et décrit un tracé temporel mesuré du courant (I) ou de la puissance (P) de l'unité d'accumulation correspondant au modèle, dans lequel le traitement de la séquence d'entrée du décodeur (324) comprend la génération, à partir de l'état initial (334) du modèle, à partir de la séquence d'entrée du décodeur (324), d'une séquence de sortie du décodeur (342), qui décrit un tracé temporel simulé de la tension (U) de l'unité d'accumulation (210) correspondant au modèle ; et
l'adaptation du modèle (310) sur la base des écarts de la séquence de sortie du décodeur (342) d'un tracé temporel de la tension (U) selon la deuxième portion (520) de la séquence d'entraînement (500).

8. Système de gestion d'accumulateur d'énergie pour un accumulateur d'énergie (200) avec au moins une unité d'accumulation (210) comprenant une mémoire de données (110) pour l'enregistrement d'un tracé temporel mesuré respectif du courant (I) et de la tension (U) ou de la puissance (P) et de la tension (U) de l'unité d'accumulation (210) respective,
**caractérisé en ce que** le système de gestion d'accumulateur d'énergie (100) comprend en outre un système de simulation (300) selon l'une des revendications 1 à 7 pour la simulation des performances de l'unité d'accumulation (210) respective de l'accumulateur d'énergie (200).

9. Procédé de simulation des performances d'au moins une unité d'accumulation (210) d'un accumulateur d'énergie (200) par un système de simulation (300), qui comprend au moins un modèle (310) respectif pour une unité d'accumulation (210) respective de l'accumulateur d'énergie, correspondant au modèle, dans lequel le modèle (310) comprend un modèle de codeur-décodeur avec un codeur (330, 332) et un décodeur (336, 338), dans lequel le modèle de codeur-décodeur comprend au moins un réseau neuronal récurrent ou au moins un réseau neuronal avec une architecture de transformateur, dans lequel le procédé comprend les étapes suivantes :
traitement d'une séquence d'entrée du codeur (322) par le codeur et génération d'un état initial (334) du modèle (310), dans lequel la séquence d'entrée du codeur (322) décrit un tracé temporel mesuré du courant (I) et de la tension (U) ou de la puissance (P) et de la tension (U) de l'unité d'accumulation (210) correspondant au modèle ; et
traitement d'une séquence d'entrée du décodeur (324) par le décodeur (336, 338) et génération d'une séquence de sortie du décodeur (342), dans lequel la séquence d'entrée du décodeur (324) décrit un tracé temporel à simuler du courant (I) ou de la puissance (P) de l'unité d'accumulation correspondant au modèle et dans lequel la séquence de sortie du décodeur (342) décrit un tracé temporel simulé de la tension (U) de l'unité d'accumulation correspondant au modèle.
